# EUROPEAN PATENT SPECIFICATION

(11) **EP 4 622 034 B1**
(45) Date of publication and mention of the grant of the patent: **25.11.2026**
(21) Application number: 23895968.8
(22) Date of filing: 27.06.2023
(51) Int. Cl.: H02H 5/12, G01R 27/02, H02J 3/38

(54) **POWER CONVERSION APPARATUS AND INSULATION IMPEDANCE OBSERVATION METHOD**
LEISTUNGSUMWANDLUNGSVORRICHTUNG UND ISOLATIONSIMPEDANZBEOBACHTUNGSVERFAHREN
APPAREIL DE CONVERSION DE PUISSANCE ET PROCÉDÉ D'OBSERVATION D'IMPÉDANCE D'ISOLATION

(30) Priority: 30.11.2022 CN 202211528570
(43) Date of publication of application: 24.09.2025
(73) Proprietor: Huawei Digital Power Technologies Co., Ltd., Shenzhen, Guangdong 518043 (CN)
(72) Inventor: LI, Luo, Shenzhen, Guangdong 518043 (CN); WANG, Jianyu, Shenzhen, Guangdong 518043 (CN); YAN, Yang, Shenzhen, Guangdong 518043 (CN); YE, Tianwei, Shenzhen, Guangdong 518043 (CN); SU, Feng, Shenzhen, Guangdong 518043 (CN); WANG, Geng, Shenzhen, Guangdong 518043 (CN)
(74) Representative: Maiwald GmbH
(86) International application number: PCT/CN2023/102917
(87) International publication number: WO 2024/113804

(56) References cited:
- EP-A1- 3 929 598
- EP-A1- 4 057 013
- CN-A- 103 475 271
- CN-A- 114 039 544
- CN-A- 114 204 594
- CN-A- 114 295 895
- CN-A- 114 295 895
- CN-A- 114 966 205
- CN-A- 115 356 540
- DE-A1- 102021 104 289
- US-A1- 2021 172 987

## Description

This application claims priority to Chinese Patent Application No. 202211528570.9, filed with the China National Intellectual Property Administration on November 30, 2022 and entitled "POWER CONVERSION APPARATUS AND INSULATION IMPEDANCE DETECTION METHOD".

### TECHNICAL FIELD

This application relates to the field of circuit technologies, and in particular, to a power conversion apparatus and an insulation impedance detection method.

### BACKGROUND

A photovoltaic (photovoltaic, PV) system usually includes a photovoltaic power generation unit and an inverter. The photovoltaic power generation unit may transmit a direct current to the inverter, and the inverter may convert the direct current into an alternating current and transmit the alternating current to a power grid. An insulation impedance between an input end of the inverter and the ground may change, causing the insulation impedance to be less than a specified impedance value. In this case, when the inverter is not grounded or poorly grounded, an electric shock accident may occur if someone touches a surface of the inverter. Therefore, to ensure safety, before the photovoltaic system is started, the insulation impedance between the input end of the inverter and the ground is first detected by using an insulation system observation (Insulation System Observation, ISO) circuit.

However, an existing insulation system observation circuit may cause a virtual voltage to be present at an output end of an inverter when the inverter is not working. Once a person touches the output end of the inverter, the person suffers an electric shock and gets numb.

EP 3 929 598 A1 discloses an example of insulation impedance detection circuit.

### SUMMARY

In view of this, this application provides a power conversion apparatus and an insulation impedance detection method, to resolve a problem that a person is caused to suffer an electric shock and hand numbness when an inverter circuit is not working. In this way, safety can be improved, and user safety experience can be improved.

According to a first aspect, this application provides a power conversion apparatus, including a direct current conversion circuit, an inverter circuit, a detection circuit, and a controller. The direct current conversion circuit is configured to output a direct current voltage. An input end of the inverter circuit is connected to the direct current conversion circuit through a direct current bus, and is configured to convert the direct current voltage into an alternating current voltage, and an output end of the inverter circuit is grounded through a Y capacitor. The detection circuit includes an insulation impedance detection circuit and an alternating current voltage detection circuit configured to detect an alternating current voltage. The insulation impedance detection circuit is connected to the direct current bus and the ground, and the alternating current voltage detection circuit is connected to the output end of the inverter circuit and the direct current bus. The controller is connected to the insulation impedance detection circuit, and may be configured to control the insulation impedance detection circuit to detect the voltage between the direct current bus and the ground, to obtain an insulation impedance between the input end of the inverter circuit and the ground based on the detected voltage. The detection circuit further includes an isolation switch. The isolation switch is connected to the insulation impedance detection circuit and the alternating current voltage detection circuit. The controller is connected to the isolation switch, and is configured to control the isolation switch to be turned off before controlling the insulation impedance detection circuit to detect the voltage between the direct current bus and the ground.

According to such a design, before the insulation impedance detection circuit detects the voltage, the power conversion apparatus in this application may turn off the isolation switch to prevent the direct current bus, the insulation impedance detection circuit, the alternating current voltage detection circuit, the output end of the inverter circuit, the Y capacitor, and the ground from being sequentially connected to form a connection path. In this way, a direct current output by the direct current conversion circuit cannot be transmitted to the Y capacitor through the connection path, so that the Y capacitor cannot be charged to generate a virtual voltage that may cause a person to suffer an electric shock and hand numbness. Therefore, the power conversion apparatus in this application can resolve a problem that a person is still caused to suffer an electric shock and hand numbness when the inverter circuit is not working. In this way, safety of the power conversion apparatus can be improved, user safety experience can be improved, and normal implementation of insulation impedance detection is not affected.

In a possible design, the isolation switch is disposed in the insulation impedance detection circuit, and/or disposed in the alternating current voltage detection circuit. It can be seen that a location of the isolation module may be flexibly disposed according to an actual situation, so that implementation of the power conversion apparatus can be flexible.

In a possible design, the detection circuit further includes a switching switch, and the switching switch is connected to the insulation impedance detection circuit and the controller. According to such a design, when controlling the isolation switch to be turned on, the controller may be configured to: control the switching switch to be turned on, and control the insulation impedance detection circuit to detect a first voltage between the direct current bus and the ground; and control the switching switch to be turned off, and control the insulation impedance detection circuit to detect a second voltage between the direct current bus and the ground, to obtain an insulation impedance based on the first voltage and the second voltage.

In a possible design, the insulation impedance detection circuit includes a first impedance element and a second impedance element. The first impedance element is connected to a positive end of the direct current bus and the ground, and the second impedance element is connected to a negative end of the direct current bus and the ground. The switching switch is connected to the first impedance element and the ground, or the switching switch is connected to the second impedance element and the ground. According to such a design, when the switching switch is connected to the first impedance element and the ground, the insulation impedance detection circuit may change an equivalent impedance of the first impedance element by using the switching switch, so that an equivalent impedance of the first impedance element when the switching switch is turned on is different from an equivalent impedance of the first impedance element when the switching switch is turned off, and an equivalent impedance of the second impedance element when the switching switch is turned on is the same as an equivalent impedance of the second impedance element when the switching switch is turned off. When the switching switch is connected to the second impedance element and the ground, the insulation impedance detection circuit may change an equivalent impedance of the second impedance element by using the switching switch, so that an equivalent impedance of the second impedance element when the switching switch is turned on is different from an equivalent impedance of the second impedance element when the switching switch is turned off, and an equivalent impedance of the first impedance element when the switching switch is turned on is the same as an equivalent impedance of the first impedance element when the switching switch is turned off. In this way, the controller may establish a system of equations based on shunting of the equivalent impedances of the first impedance element and the second impedance element when the switching switch is turned on, and the equivalent impedances of the first impedance element and the second impedance element when the switching switch is turned off, and substitute the first voltage and the second voltage into the system of equations, to obtain the insulation impedance through solution.

In a possible design, both the first voltage and the second voltage are voltages between the negative end of the direct current bus and the ground. Both the first voltage and the second voltage may participate in calculation of the insulation impedance.

In a possible design, the controller is further configured to: when controlling the isolation switch to be turned off, control the inverter circuit not to work.

According to a second aspect, this application further provides an insulation impedance detection method, applied to a power conversion apparatus. The power conversion apparatus includes a direct current conversion circuit, an inverter circuit, a detection circuit, and a controller. An input end of the inverter circuit is connected to the direct current conversion circuit through a direct current bus, and an output end of the inverter circuit is grounded through a Y capacitor. The detection circuit includes an insulation impedance detection circuit and an alternating current voltage detection circuit, the insulation impedance detection circuit is connected to the direct current bus and the ground, and the alternating current voltage detection circuit is connected to the output end of the inverter circuit and the direct current bus. The insulation impedance detection method includes: controlling an isolation switch to be turned on, and controlling the insulation impedance detection circuit to detect a voltage between the direct current bus and the ground, to obtain an insulation impedance between the input end of the inverter circuit and the ground based on the detected voltage, where the isolation switch is connected to the insulation impedance detection circuit and the alternating current voltage detection circuit. The insulation impedance detection method further includes: before controlling the insulation impedance detection circuit to detect the voltage between the direct current bus and the ground, controlling the isolation switch to be turned off.

According to such a design, in the insulation impedance detection method in this application, before the insulation impedance detection circuit detects the voltage, the isolation switch may be turned off to prevent a direct current output by the direct current conversion circuit from charging the capacitor Y. Therefore, a virtual voltage generated by the capacitor Y can be eliminated, and a problem that a person is caused to suffer an electric shock and hand numbness due to a virtual voltage when the inverter circuit is not working can be resolved. In this way, safety of the power conversion apparatus can be improved, user safety experience can be improved, and normal implementation of insulation impedance detection is not affected.

In a possible design, the detection circuit further includes a switching switch, and the switching switch is connected to the insulation impedance detection circuit and the controller. When the isolation switch is controlled to be turned on, the insulation impedance detection method further includes: controlling the switching switch to be turned on, and controlling the insulation impedance detection circuit to detect a first voltage between the direct current bus and the ground; and controlling the switching switch to be turned off, and controlling the insulation impedance detection circuit to detect a second voltage between the direct current bus and the ground. In this way, an insulation impedance can be obtained based on the first voltage and the second voltage.

In a possible design, the insulation impedance detection circuit includes a first impedance element and a second impedance element. The first impedance element is connected to a positive end of the direct current bus and the ground, and the second impedance element is connected to a negative end of the direct current bus and the ground. The switching switch is connected to the first impedance element and the ground, or the switching switch is connected to the second impedance element and the ground. When the switching switch is connected to the first impedance element and the ground, an equivalent impedance of the first impedance element when the switching switch is turned on is different from an equivalent impedance of the first impedance element when the switching switch is turned off, and an equivalent impedance of the second impedance element when the switching switch is turned on is the same as an equivalent impedance of the second impedance element when the switching switch is turned off. When the switching switch is connected to the second impedance element and the ground, an equivalent impedance of the second impedance element when the switching switch is turned on is different from an equivalent impedance of the second impedance element when the switching switch is turned off, and an equivalent impedance of the first impedance element when the switching switch is turned on is the same as an equivalent impedance of the first impedance element when the switching switch is turned off. The insulation impedance detection method further includes: establishing a system of equations based on shunting of the equivalent impedances of the first impedance element and the second impedance element when the switching switch is turned on, and the equivalent impedances of the first impedance element and the second impedance element when the switching switch is turned off, and substituting the first voltage and the second voltage into the system of equations, to obtain the insulation impedance through calculation.

In a possible design, the insulation impedance detection method further includes: when the isolation switch is controlled to be turned off, controlling the inverter circuit not to work.

According to a third aspect, this application further provides a power supply system. The power supply system includes the power conversion apparatus according to any one of the first aspect or the possible implementations of the first aspect.

In a possible design, the power supply system is a photovoltaic system.

In addition, for technical effects brought by any one of the possible implementations of the second aspect and the third aspect, refer to technical effects brought by different implementations of the first aspect. Details are not described herein again.

### BRIEF DESCRIPTION OF DRAWINGS

FIG. 1 is a diagram of a short circuit of an inverter caused by a failure of insulation between a photovoltaic power generation unit and the ground;
FIG. 2 is a diagram of an electric shock accident caused by an inverter;
FIG. 3 is a diagram of a power conversion apparatus according to an embodiment of this application;
FIG. 4 is a diagram of another power conversion apparatus according to an embodiment of this application;
FIG. 5A is a diagram of a connection of an isolation switch in FIG. 4 in a detection circuit;
FIG. 5B is a diagram of another connection of an isolation switch in FIG. 4 in a detection circuit;
FIG. 5C is a diagram of another connection of an isolation switch in FIG. 4 in a detection circuit;
FIG. 5D is a diagram of another connection of an isolation switch in FIG. 4 in a detection circuit;
FIG. 5E is a diagram of another connection of an isolation switch in FIG. 4 in a detection circuit;
FIG. 5F is a diagram of another connection of an isolation switch in FIG. 4 in a detection circuit;
FIG. 5G is a diagram of another connection of an isolation switch in FIG. 4 in a detection circuit;
FIG. 5H is a diagram of another connection of an isolation switch in FIG. 4 in a detection circuit;
FIG. 5I is a diagram of another connection of an isolation switch in FIG. 4 in a detection circuit;
FIG. 5J is a diagram of another connection of an isolation switch in FIG. 4 in a detection circuit;
FIG. 6 is a flowchart of an insulation impedance detection method according to an embodiment of this application; and
FIG. 7 is a diagram of a power supply system according to an embodiment of this application.

**Descriptions of reference numerals of main elements**

| | |
|---|---|
| Power conversion apparatus | 100, 100a, 100b, 100c, 100d, 100e, |
| | 100f, 100g, 100h, 100i, 100j, 100k |
| Direct current conversion circuit | 1 |
| Inverter circuit | 2 |
| Detection circuit | 3 |
| Insulation impedance detection circuit | 31 |
| First impedance element | 311 |
| Second impedance element | 312 |
| Voltage sampling circuit | 313 |
| Switching switch | 32 |
| Alternating current voltage detection circuit | 33 |
| Isolation switch | 34 |
| Controller | 4 |
| Power supply system | 1000 |

In the following specific implementations, this application is further described with reference to the accompanying drawings.

### DESCRIPTION OF EMBODIMENTS

The following clearly and completely describes the technical solutions in embodiments of this application with reference to the accompanying drawings in embodiments of this application.

It may be understood that a connection relationship described in this application is a direct or indirect connection. For example, that A is connected to B may be that A is directly connected to B, or that A is indirectly connected to B through one or more other electrical components, for example, A is directly connected to C, and C is directly connected to B, so that A is connected to B through C. It may be further understood that "A is connected to B" described in this application may be that A is directly connected to B, or may be that A is indirectly connected to B through one or more other electrical components.

In descriptions of this application, unless otherwise specified, "/" means "or". For example, A/B may mean A or B. A term "and/or" in this specification describes only an association relationship between associated objects and indicates that three relationships may exist. For example, A and/or B may represent the following three cases: Only A exists, both A and B exist, and only B exists.

In the descriptions of this application, words such as "first" and "second" are merely used to distinguish between different objects, and do not limit a quantity and an execution sequence. In addition, the words such as "first" and "second" do not indicate a definite difference. In addition, terms such as "include" and "have" and any variants thereof are intended to cover a non-exclusive inclusion.

A photovoltaic (photovoltaic, PV) system usually includes a photovoltaic power generation unit and an inverter. The photovoltaic power generation unit may transmit a direct current to the inverter through a direct current bus, and the inverter may convert the direct current into an alternating current. During actual operating of the photovoltaic system, an insulation impedance between an input end of the inverter and the ground may change. It may be understood that the insulation impedance represents insulation between the input end of the inverter and the ground, and the insulation impedance is a virtual impedance.

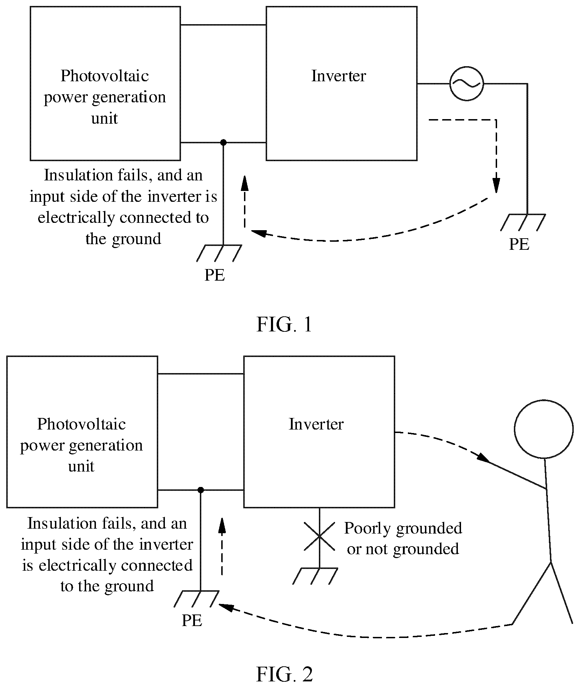

As shown in FIG. 1, when the insulation impedance changes to be less than a specified impedance value Umax.pv/30 mA (Umax.pv is a maximum output voltage of a photovoltaic array in the photovoltaic power generation unit), it is equivalent to that insulation between the input end of the inverter and the ground fails, which may cause a short circuit failure of the inverter. Therefore, in this case, for an isolation-type inverter, a fault should be indicated, but the inverter can still perform other actions and operations. For a non-isolation inverter or an isolation-type inverter whose leakage current does not meet a requirement, a fault should be indicated, and the inverter should be restricted from accessing a power grid. Otherwise, as shown in FIG. 2, when the insulation impedance is less than the specified impedance value, and the inverter is poorly grounded or not grounded, a housing of the inverter is electrified. When someone touches the housing of the inverter, an electric shock accident may occur. Therefore, to ensure safety, before the photovoltaic system is started, the insulation impedance between the input end of the inverter and the ground is first detected by using an insulation system observation (Insulation System Observation, ISO) circuit.

However, an existing insulation system observation circuit may cause a virtual voltage to be present at an output end of an inverter when the inverter is not working. This is because the insulation impedance detection circuit is connected to a direct current bus, and an alternating current voltage detection circuit on the output end of the inverter uses a negative end of the direct current bus as a reference ground. Therefore, the negative end of the direct current bus is also connected to the alternating current voltage detection circuit. In this way, the direct current bus, the insulation system observation circuit, the alternating current voltage detection circuit, and the output end of the inverter are connected to form a connection path. In this case, even if the inverter is not working, a direct current output by the photovoltaic power generation unit may also be transmitted to the output end of the inverter through the connection path, to charge a Y capacitor (the Y capacitor is connected between the output end of the inverter and a protecting earthing PE wire) on the output end of the inverter, so that a virtual voltage is generated. The virtual voltage may cause an electric shock to a person who touches the output end of the inverter by mistake, causing the person to get numb.

Therefore, embodiments of this application provide a power conversion apparatus and an insulation impedance detection method, to resolve a problem that a person is caused to suffer an electric shock and hand numbness due to a virtual voltage generated when the inverter circuit is not working. In this way, safety of the power conversion apparatus is improved, and user safety experience is improved.

The technical solutions of this application are further described below in detail with reference to the accompanying drawings.

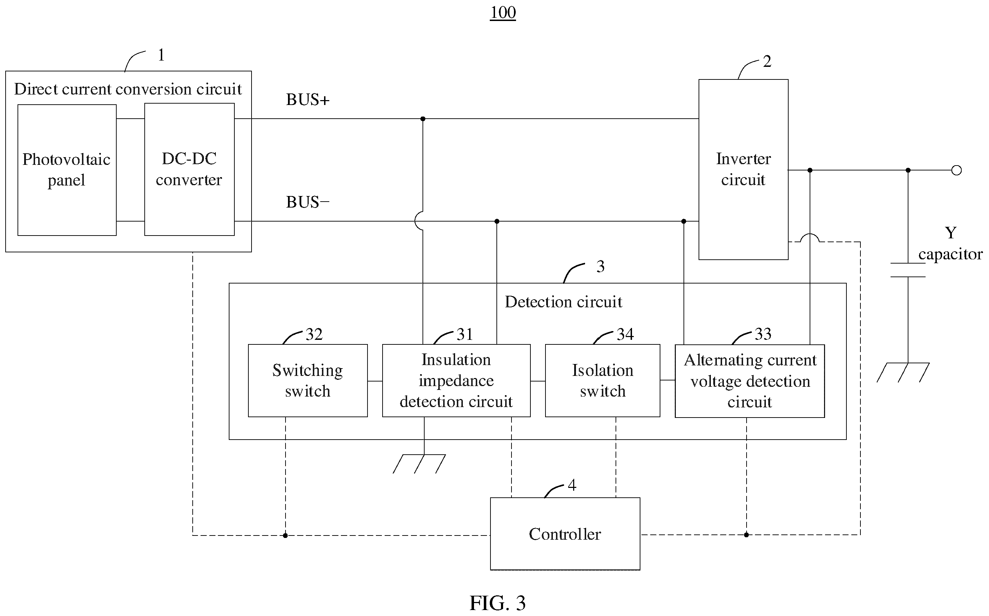

FIG. 3 shows a power conversion apparatus 100 according to an embodiment of this application.

As shown in FIG. 3, the power conversion apparatus 100 includes a direct current conversion circuit 1 and an inverter circuit 2. The direct current conversion circuit 1 is connected to an input end of the inverter circuit 2 through a direct current bus. The direct current conversion circuit 1 may be configured to output a direct current voltage, and the inverter circuit 2 may be configured to convert the direct current voltage output by the direct current conversion circuit 1 into an alternating current voltage. An output end of the inverter circuit 2 may be configured to connect to a power grid or an alternating current load.

It may be understood that the direct current bus has a positive end (that is, BUS+ in FIG. 3) and a negative end (that is, BUS- in FIG. 3).

It may be understood that the direct current conversion circuit 1 and the inverter circuit 2 are not specifically limited in embodiments of this application, provided that the direct current conversion circuit 1 and the inverter circuit 2 can implement corresponding functions.

For ease of description, an example in which the direct current conversion circuit 1 is a photovoltaic power generation unit is used for description in embodiments of this application. As shown in FIG. 3, the direct current conversion circuit 1 includes a photovoltaic panel and a direct current to direct current (Direct Current to Direct Current, DC-DC) converter. It may be understood that a quantity of photovoltaic panels is not specifically limited herein. The photovoltaic panel is connected to an input end of the DC-DC converter, and an output end of the DC-DC converter is connected to the input end of the inverter circuit 2 through the direct current bus. The photovoltaic panel may convert solar energy into a direct current, to output a direct current voltage to the DC-DC converter. The DC-DC converter may convert the direct current voltage generated by the photovoltaic panel into another stable direct current voltage.

For ease of description, an example in which the inverter circuit 2 is a single-phase inverter is used for description in embodiments of this application. As shown in FIG. 3, the output end of the inverter circuit 2 is single-phase. Certainly, in another implementation, the inverter circuit 2 may alternatively be a multi-phase inverter, and the output end of the inverter circuit 2 is multi-phase.

It may be understood that, as shown in FIG. 3, in consideration of safety, the output end of the inverter circuit 2 is connected to a protecting earthing (Protecting Earthing, PE) wire through a Y capacitor. The PE wire is grounded.

Refer to FIG. 3 again. The power conversion apparatus 100 further includes a controller 4. The controller 4 is connected to the direct current conversion circuit 1 and the inverter circuit 2, and may be configured to control working of the direct current conversion circuit 1 and the inverter circuit 2.

It may be understood that the controller 4 may be a general-purpose central processing unit (CPU), a digital signal processor (DSP, Digital Signal Processor), microprocessor, an application-specific integrated circuit (application-specific integrated circuit, ASIC), or one or more integrated circuits configured to control execution of the foregoing solution program.

To enable the controller 4 to monitor the working of the inverter circuit 2, still refer to FIG. 3. The power conversion apparatus 100 further includes a detection circuit 3. The detection circuit 3 includes an insulation impedance detection circuit 31 and an alternating current voltage detection circuit 33.

The insulation impedance detection circuit 31 is connected to the direct current bus and the ground. Therefore, the insulation impedance detection circuit 31 may be configured to detect a voltage between the direct current bus and the ground. The insulation impedance detection circuit 31 is connected to the controller 4. Based on this, the controller 4 may obtain an insulation impedance based on the voltage detected by the insulation impedance detection circuit 31, to correspondingly control working of the inverter circuit 2 based on a value of the insulation impedance.

In embodiments of this application, the insulation impedance detection circuit 31 may be specifically configured to detect a voltage between the negative end BUS- of the direct current bus and the ground.

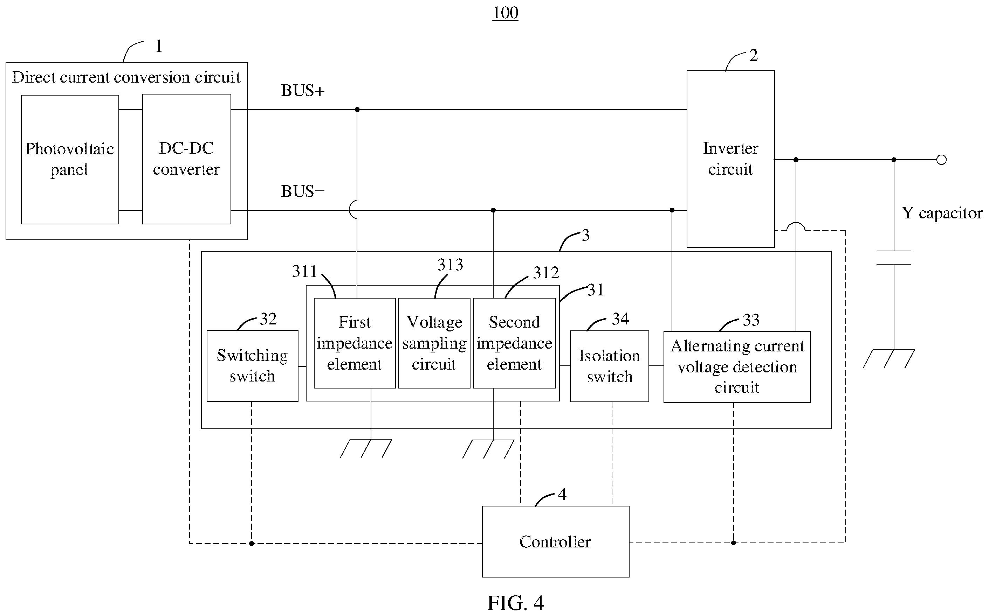

Specifically, in embodiments of this application, as shown in FIG. 4, the insulation impedance detection circuit 31 may include a first impedance element 311 and a second impedance element 312. The first impedance element 311 is connected to the positive end BUS+ of the direct current bus and the ground, and the second impedance element 312 is connected to the negative end BUS- of the direct current bus and the ground.

It may be understood that the first impedance element 311 may be a resistor, or may include at least one resistor and another electronic component (for example, a fuse) that are connected in series, in parallel, or in both series and parallel. This is not specifically limited in this application. A circuit of the second impedance element 312 is the same as or similar to that of the first impedance element 311. Details are not described herein again. Therefore, it may be understood that, that the first impedance element 311 is connected to BUS+ may be equivalent to that BUS+ is connected to a corresponding impedance, and that the second impedance element 312 is connected to BUS- may be equivalent to that BUS- is connected to a corresponding impedance.

It may be understood that the input end of the inverter circuit 2 has a positive electrode and a negative electrode, where an insulation impedance R+ exists between the positive electrode of the input end of the inverter circuit 2 and the ground, and an insulation impedance R- exists between the negative electrode of the input end of the inverter circuit 2 and the ground. A value of R+ represents an insulation status between the positive electrode of the input end of the inverter circuit 2 and the ground, and a value of R- represents an insulation status between the negative electrode of the input end of the inverter circuit 2 and the ground. An insulation impedance between the input end of the inverter circuit 2 and the ground is equal to a parallel connection between R+ and R-. Therefore, an equivalent impedance between BUS+ and the ground may be equal to a parallel connection between R+ and an impedance connected to BUS+, and an equivalent impedance between BUS- and the ground may be equal to a parallel connection between R- and an impedance connected to BUS-.

It may be understood that the insulation impedance detection circuit 31 further includes a voltage sampling circuit 313, and the voltage sampling circuit 313 may be any circuit that can implement a voltage sampling function. This is not specifically limited in embodiments of this application. The voltage sampling circuit 313 may perform sampling on a voltage between two ends of the second impedance element 312 to obtain a voltage between the negative end BUS- of the direct current bus and the ground.

As shown in FIG. 3, a switching switch 32 may be disposed in the detection circuit 3, and the switching switch 32 may be connected to the first impedance element 311 and the ground. According to such a design, when the switching switch 32 switches between an on state and an off state, an impedance connected to BUS+ may change. Therefore, an equivalent impedance (for ease of description, referred to as a first equivalent impedance below) of the first impedance element 311 when the switching switch 32 is turned on is different from an equivalent impedance (for ease of description, referred to as a second equivalent impedance below) of the first impedance element 311 when the switching switch 32 is turned off. An equivalent impedance (for ease of description, referred to as a third equivalent impedance below) of the second impedance element 312 when the switching switch 32 is turned on and an equivalent impedance (for ease of description, referred to as a fourth equivalent impedance below) of the second impedance element 312 when the switching switch 32 is turned off remain unchanged and are still the same.

Certainly, the switching switch 32 may alternatively be connected to the second impedance element 312 and the ground. According to such a design, when the switching switch 32 switches between an on state and an off state, an impedance connected to BUS- may change. Therefore, a third equivalent impedance is different from a fourth equivalent impedance, and a first equivalent impedance is the same as a second equivalent impedance.

The switching switch 32 is connected to the controller 4. Therefore, the controller 4 may be configured to control the switching switch 32 to be turned on or turned off, to change an equivalent impedance of the insulation impedance detection circuit 31. In addition, when controlling the switching switch 32 to be turned on, the controller 4 further controls the insulation impedance detection circuit 31 to detect a first voltage U1 between the negative end BUS- of the direct current bus and the ground, and when controlling the switching switch 32 to be turned off, the controller 4 further controls the insulation impedance detection circuit 31 to detect a second voltage U2 between the negative end BUS- of the direct current bus and the ground.

In this way, the controller 4 may separately establish corresponding KCL equations based on shunting of the first equivalent impedance and the third equivalent impedance and shunting of the second equivalent impedance and the fourth equivalent impedance, to obtain a KCL system of equations, and then substitute the first voltage U1 and the second voltage U2 into the KCL system of equations, to solve R+ and R-. In this way, it can be learned that an insulation impedance between the input end of the inverter circuit 2 and the ground is a parallel connection between R+ and R-.

Further, the controller 4 may determine whether the insulation impedance between the input end of the inverter circuit 2 and the ground is less than a preset impedance value (for example, Umax.pv/30 mA, where Umax.pv is a maximum output voltage of all photovoltaic panels in the direct current conversion circuit 1).

When it is determined that the insulation impedance between the input end of the inverter circuit 2 and the ground is less than the preset impedance value, it indicates that insulation between the input end of the inverter circuit 2 and the ground fails. If the inverter circuit 2 is controlled to work in this case, the inverter circuit 2 may be short-circuited and fail. Therefore, in this case, the controller 4 controls the inverter circuit 2 not to work. On the contrary, when it is determined that the insulation impedance between the input end of the inverter circuit 2 and the ground is not less than the preset impedance value, it indicates that insulation between the input end of the inverter circuit 2 and the ground is good. Therefore, the controller 4 can control the inverter circuit 2 to work.

It can also be learned from this that insulation impedance detection is performed before the inverter circuit 2 works, and in an insulation impedance detection process, the direct current conversion circuit 1 is in a working state. In other words, the DC-DC converter can generate a direct current as long as the photovoltaic panel is exposed to sunlight.

It may be understood that the switching switch 32 may be a switch device, or may be a switch circuit including at least one switch device and another electronic component (for example, a resistor) that are connected in series, in parallel, or in both series and parallel. This is not specifically limited in this application. The switch device may be a mechanical switch or a semiconductor switch. The mechanical switch includes but is not limited to a relay or a contactor. The semiconductor switch includes but is not limited to a silicon controlled rectifier (Silicon Controlled Rectifier, SCR), a metal oxide semiconductor field effect transistor (metal oxide semiconductor field effect transistor, MOSFET), an insulated gate bipolar transistor (insulated gate bipolar transistor, IGBT), and a gallium nitride high electron mobility transistor (high electron mobility transistor, GaN HEMT).

It may be understood that, in embodiments of this application, the switching switch 32 may be in an always-on state.

Still refer to FIG. 3 and FIG. 4. The alternating current voltage detection circuit 33 is connected to the output end of the inverter circuit 2 and the negative end BUS- of the direct current bus.

It may be understood that the alternating current voltage detection circuit 33 may be any circuit that can implement an alternating current voltage sampling function. This is not specifically limited in embodiments of this application. The alternating current voltage detection circuit 33 may be configured to detect an alternating current voltage at the output end of the inverter circuit 2 by using BUS- as a reference ground.

It may be understood that, when the inverter circuit 2 is a multi-phase inverter, the alternating current voltage detection circuit 33 may be connected to each phase of the output end of the inverter circuit 2, and detect an alternating current voltage output by each phase of the output end of the inverter circuit 2.

As described above, the insulation impedance detection circuit 31 is connected to BUS-, and the alternating current voltage detection circuit 33 is also connected to BUS-. Therefore, the insulation impedance detection circuit 31 may be connected to the alternating current voltage detection circuit 33. The alternating current voltage detection circuit 33 is further connected to the output end of the inverter circuit 2, and the output end of the inverter circuit 2 is further grounded through the Y capacitor. Therefore, the direct current bus, the insulation impedance detection circuit 31, the alternating current voltage detection circuit 33, the output end of the inverter circuit 2, the Y capacitor, and the ground may be connected to form a connection path. In addition, the insulation impedance detection circuit 31 is further grounded, so that the connection path is closed.

Therefore, it may be understood that, as long as the direct current conversion circuit 1 outputs a direct current, the direct current may be transmitted to the output end of the inverter circuit 2 through the connection path, to charge the Y capacitor on the output end of the inverter circuit 2, so that the Y capacitor generates a virtual voltage. It is clear that, in this case, even if the inverter circuit 2 is not working, a safety problem that a person is caused to suffer an electric shock and hand numbness via the output end of the inverter circuit 2 still occurs.

Therefore, to eliminate the virtual voltage, as shown in FIG. 3 and FIG. 4, the detection circuit 3 further includes an isolation switch 34. The isolation switch 34 is connected to the insulation impedance detection circuit 31 and the alternating current voltage detection circuit 33. Turning off the isolation switch 34 may prevent the insulation impedance detection circuit 31 from being connected to the alternating current voltage detection circuit 33, that is, the connection path is disconnected.

It may be understood that the isolation switch 34 may be a switch device, or may be a switch circuit including at least one switch device and another electronic component (for example, a resistor) that are connected in series, in parallel, or in both series and parallel. This is not specifically limited in this application. For the switch device, refer to the descriptions in the foregoing switching switch 32. Details are not described herein again.

It may be understood that, in embodiments of this application, the isolation switch 34 may be in an always-on state.

In embodiment of this application, the isolation switch 34 is connected to the controller 4. Therefore, the controller 4 may be configured to control the isolation switch 34 to be turned off before controlling the insulation impedance detection circuit 31 to detect the voltage between the direct current bus and the ground, that is, before the insulation impedance detection, so that the connection path is disconnected. In this way, the Y capacitor on the output end of the inverter circuit 2 cannot obtain the direct current through the connection path. Therefore, the Y capacitor cannot generate a virtual voltage. In this way, a problem that a person is caused to suffer an electric shock and hand numbness due to a virtual voltage is resolved.

During insulation impedance detection, the controller 4 may be configured to control the isolation switch 34 to be turned on, to enable the connection path to be connected, and then control the insulation impedance detection circuit 31 to detect a voltage between the direct current bus and the ground, to obtain the insulation impedance based on the detected voltage.

It may be understood that, in a period in which the isolation switch 34 is turned off and in an insulation impedance detection process, the controller 4 controls the inverter circuit 2 not to work.

It may be understood that, as described above, the insulation impedance detection is performed before the inverter circuit 2 works. When the controller 4 controls the insulation impedance detection circuit 31 to detect the voltage, it means that the inverter circuit 2 may be about to work. In this case, for safety purposes, a person usually does not approach the inverter circuit 2. Therefore, in embodiments of this application, a case in which a person may contact the output end of the inverter circuit 2 and suffer hand numbness before the insulation impedance detection circuit 31 detects the voltage is considered.

In some implementations, the controller 4 may be communicatively connected to an upper computer, and the upper computer may send a corresponding control instruction to the controller 4. The control instruction indicates the inverter circuit 2 whether to work. After the controller 4 receives the control instruction, if the control instruction instructs the inverter circuit 2 to work, the controller 4 may control the isolation switch 34 to be turned on, to obtain the insulation impedance through the foregoing process. When the insulation impedance is not less than the preset impedance value, the controller 4 controls the inverter circuit 2 to work. When the insulation impedance is less than the preset impedance value, or the control instruction instructs the inverter circuit 2 not to work, the control circuit controls the inverter circuit 2 not to work.

Certainly, in some other embodiments, the controller 4 may further detect power output by the direct current conversion circuit 1. When the power output by the direct current conversion circuit 1 reaches a preset power value, the controller 4 may control the isolation switch 34 to be turned on, to obtain the insulation impedance through the foregoing process. When the insulation impedance is not less than the preset impedance value, the controller 4 controls the inverter circuit 2 to work. When the insulation impedance is less than the preset impedance value, or the power output by the direct current conversion circuit 1 does not reach the preset power value, the control circuit controls the inverter circuit 2 not to work.

It may be understood that a specific location of the isolation switch 34 in the detection circuit 3 is not specifically limited in embodiments of this application. For example, the isolation switch 34 may be disposed in the insulation impedance detection circuit 31, and/or disposed in the alternating current voltage detection circuit 33. For ease of understanding, the following describes a location of the isolation switch 34 in detail using Embodiment 1 to Embodiment 10. In Embodiment 1 to Embodiment 4, the isolation switch 34 is disposed in the insulation impedance detection circuit 31, and in Embodiment 5 to Embodiment 10, the isolation switch 34 is disposed in the alternating current voltage detection circuit 33.

### Embodiment 1

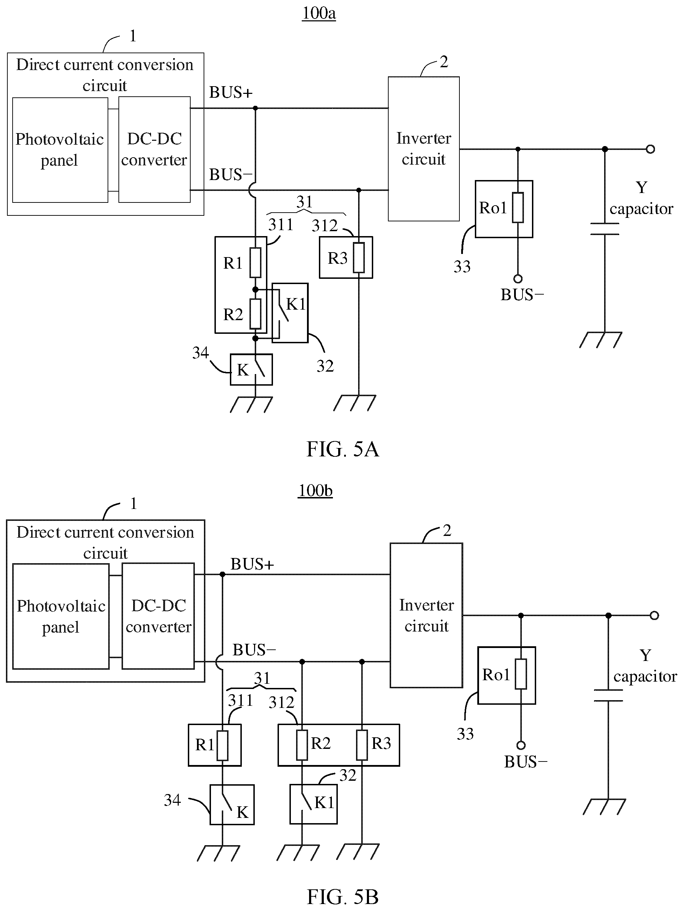

As shown in FIG. 5A, in a power conversion apparatus 100a, the insulation impedance detection circuit 31 includes the first impedance element 311 and the second impedance element 312, where the first impedance element 311 includes resistors R1 and R2, and the second impedance element 312 is a resistor R3. The alternating current voltage detection circuit 33 includes a resistor Ro1. The switching switch 32 is a switch device K1. The isolation switch 34 is a switch device K.

As shown in FIG. 5A, one end of the resistor R1 is connected to a positive end BUS+ of a direct current bus, and the other end is sequentially connected to one end of the resistor R2 and one end of the isolation switch 34. The other end of the isolation switch 34 is connected to a PE wire for grounding. One end of the resistor R3 is connected to a negative end BUS- of the direct current bus, and the other end is connected to a PE wire for grounding. The switching switch 32 is connected in parallel to the resistor R2. One end of the resistor Ro1 is connected to an output end of the inverter circuit 2, and the other end is connected to BUS-.

According to such a design, when the controller 4 controls the isolation switch 34 to be turned off, a connection between BUS+ and the PE wire is disconnected, so that a closed connection path including the direct current bus, the insulation impedance detection circuit 31, the alternating current voltage detection circuit 33, the output end of the inverter circuit 2, the Y capacitor, and the ground is disconnected. In this case, a large part of a direct current voltage may be obtained through distribution from BUS+ to the PE wire, that is, a voltage between BUS+ and the PE wire is large, and a voltage between BUS- and the PE wire is small. Therefore, even if BUS- is connected to the output end of the inverter circuit 2 through the resistor Ro1, the Y capacitor on the output end cannot be charged to generate a virtual voltage. It can be learned that a problem that a person is caused to suffer an electric shock and hand numbness via the output end of the inverter circuit 2 can be resolved.

When the controller 4 controls the isolation switch 34 to be turned on, BUS+ and the PE wire are connected. In this case, when the controller 4 controls the switching switch 32 to be turned on, an equivalent impedance between BUS+ and the ground is a parallel connection between R+ and R1 plus R2. When the controller 4 controls the switching switch 32 to be turned on, R2 is short-circuited. Therefore, an equivalent impedance between BUS+ and the ground is a parallel connection between R+ and R1. An equivalent impedance between BUS- and the ground is always a parallel connection between R-, R3, and Ro1. For a process of calculating the insulation impedance by the controller 4, refer to the foregoing content. Details are not described herein again.

### Embodiment 2

As shown in FIG. 5B, in a power conversion apparatus 100b, the insulation impedance detection circuit 31 includes the first impedance element 311 and the second impedance element 312. The alternating current voltage detection circuit 33 includes a resistor Ro1. The switching switch 32 is a switch device K1. The isolation switch 34 is a switch device K.

A difference between the power conversion apparatus 100b in Embodiment 2 and the power conversion apparatus 100a in Embodiment 1 lies in structures of the first impedance element 311 and the second impedance element 312 and connection relationships between the first impedance element 311, the second impedance element 312, the isolation switch 34, and the switching switch 32.

As shown in FIG. 5B, the first impedance element 311 is a resistor R1, and the second impedance element 312 includes resistors R2 and R3. One end of the resistor R1 is connected to BUS+, and the other end is connected to a PE wire through the isolation switch 34 for grounding. One end of the resistor R2 is connected to BUS-, and the other end is connected to a PE wire through the switching switch 32 for grounding. One end of the resistor R3 is connected to BUS-, and the other end is connected to a PE wire for grounding.

According to such a design, when the controller 4 controls the isolation switch 34 to be turned off, a connection between BUS+ and the PE wire is disconnected. In this case, a large part of a direct current voltage may be obtained through distribution from BUS+ to the PE wire, that is, a voltage between BUS+ and the PE wire is large, and a voltage between BUS- and the PE wire is small. Therefore, the Y capacitor on the output end of the inverter circuit 2 cannot be charged to generate a virtual voltage, and a problem that a person is caused to suffer an electric shock and hand numbness via the output end of the inverter circuit 2 is resolved.

When the controller 4 controls the isolation switch 34 to be turned on, BUS+ and the PE wire are connected. In this case, when the controller 4 controls the switching switch 32 to be turned on, an equivalent impedance between BUS- and the ground is a parallel connection between R-, R2, R3, and Ro1. When the controller 4 controls the switching switch 32 to be turned on, an equivalent impedance between BUS- and the ground is always a parallel connection between R-, R3, and Ro1. An equivalent impedance between BUS+ and the ground is always a parallel connection between R+ and R1.

It may be understood that, in some implementations, locations of K and K1 may alternatively be exchanged, that is, K is used as the switching switch 32, and K1 is used as the isolation switch 34. It may be understood that, the exchange of locations of K and K1 does not affect normal working of the power conversion apparatus 100b in Embodiment 2.

### Embodiment 3

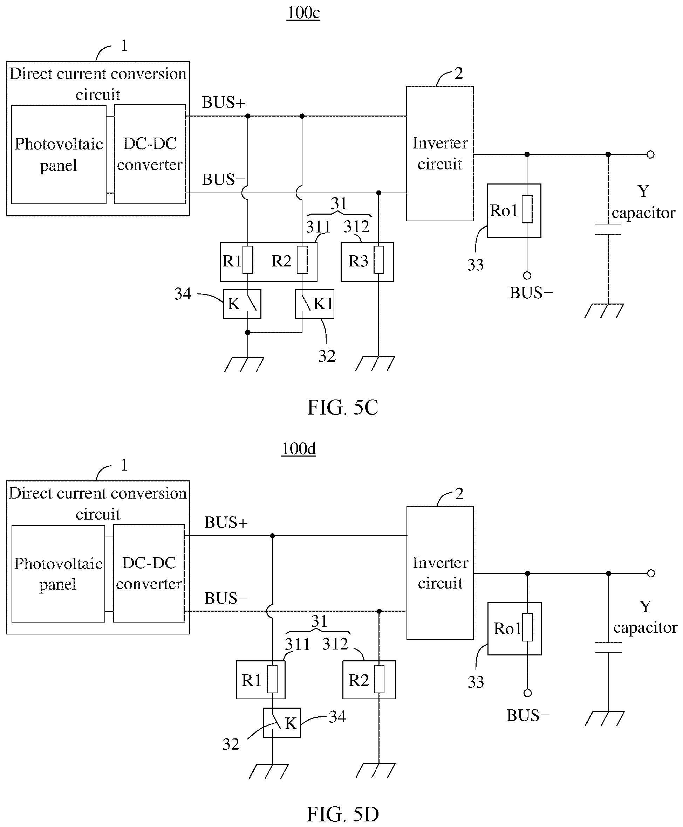

As shown in FIG. 5C, in a power conversion apparatus 100c, the insulation impedance detection circuit 31 includes the first impedance element 311 and the second impedance element 312. The alternating current voltage detection circuit 33 includes a resistor Ro1. The switching switch 32 is a switch device K1. The isolation switch 34 is a switch device K.

A difference between the power conversion apparatus 100c in Embodiment 3 and the power conversion apparatus 100a in Embodiment 1 lies in a structure of the first impedance element 311 and connection relationships between the first impedance element 311, the second impedance element 312, the isolation switch 34, and the switching switch 32.

As shown in FIG. 5C, the first impedance element 311 includes resistors R1 and R2, and the second impedance element 312 is a resistor R3. One end of the resistor R1 is connected to BUS+, and the other end is connected to a PE wire through the isolation switch 34 for grounding. One end of the resistor R2 is connected to BUS+, and the other end is connected to a PE wire through the switching switch 32 for grounding. One end of the resistor R3 is connected to BUS-, and the other end is connected to a PE wire for grounding.

According to such a design, when the controller 4 controls the isolation switch 34 to be turned off, because the switching switch 32 is also in an always-on state, a connection between BUS+ and the PE wire is disconnected at this time, so that the Y capacitor on the output end of the inverter circuit 2 cannot be charged to generate a virtual voltage.

When the controller 4 controls the isolation switch 34 to be turned on, BUS+ and the PE wire are connected. In this case, when the controller 4 controls the switching switch 32 to be turned on, an equivalent impedance between BUS+ and the ground is a parallel connection between R+ and R1. When the controller 4 controls the switching switch 32 to be turned on, an equivalent impedance between BUS+ and the ground is always a parallel connection between R+, R1, and R2. An equivalent impedance between BUS- and the ground is always a parallel connection between R-, R3, and Ro1.

It may be understood that, in some implementations, locations of K and K1 may alternatively be exchanged, that is, K is used as the switching switch 32, and K1 is used as the isolation switch 34. It may be understood that, the exchange of locations of K and K1 does not affect normal working of the power conversion apparatus 100c in Embodiment 3.

### Embodiment 4

As shown in FIG. 5D, in a power conversion apparatus 100d, the insulation impedance detection circuit 31 includes the first impedance element 311 and the second impedance element 312. The alternating current voltage detection circuit 33 includes a resistor Ro1.

A difference between the power conversion apparatus 100d in Embodiment 4 and the power conversion apparatus 100a in Embodiment 1 lies in the first impedance element 311, the isolation switch 34, and the switching switch 32.

As shown in FIG. 5D, the isolation switch 34 is a switch device K, and the isolation switch 34 is reused as the switching switch 32. In this way, electronic components in the power conversion apparatus 100d can be reduced, and the costs, a weight, and a volume of the power conversion apparatus 100d can be reduced.

The first impedance element 311 is a resistor R1, and the second impedance element 312 is a resistor R2. One end of the resistor R1 is connected to BUS+, and the other end is connected to a PE wire through the isolation switch 34 (that is, the switching switch 32) for grounding. One end of the resistor R2 is connected to BUS-, and the other end is connected to a PE wire for grounding.

It may be understood that, for a process in which the controller 4 controls the isolation switch 34 (that is, the switching switch 32) and calculates the insulation impedance, refer to Embodiment 1. Details are not described herein again.

### Embodiment 5

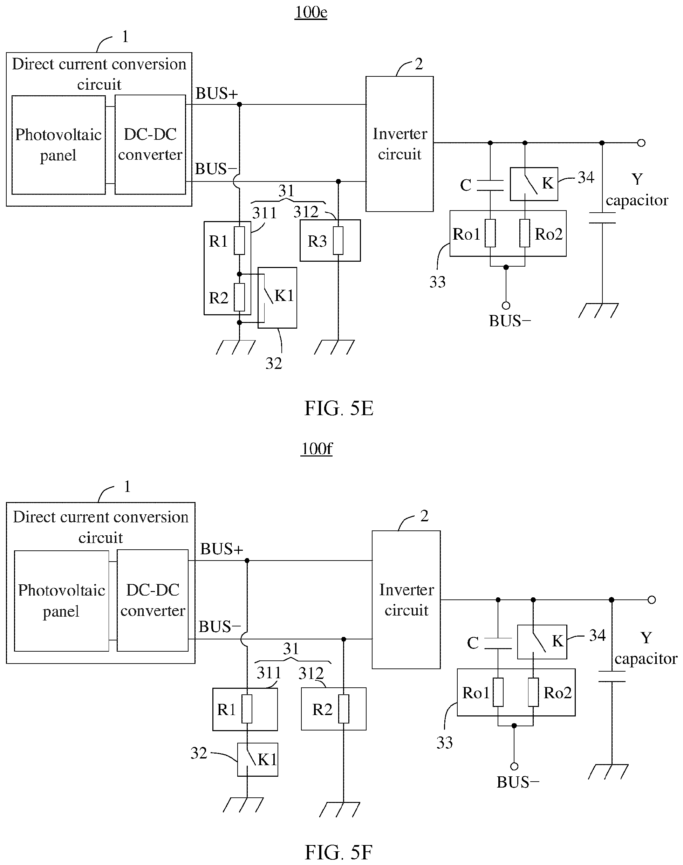

As shown in FIG. 5E, in a power conversion apparatus 100e, the insulation impedance detection circuit 31 includes the first impedance element 311 and the second impedance element 312. The switching switch 32 is a switch device K1. The isolation switch 34 is a switch device K.

A difference between the power conversion apparatus 100e in Embodiment 5 and the power conversion apparatus 100a in Embodiment 1 lies in a circuit structure of the alternating current voltage detection circuit 33, a connection relationship between the first impedance element 311 and the switching switch 32, and a connection relationship between the second impedance element 312, the alternating current voltage detection circuit 33, and the isolation switch 34.

As shown in FIG. 5E, the alternating current voltage detection circuit 33 includes resistors Ro1 and Ro2. The first impedance element 311 includes resistors R1 and R2, and the second impedance element 312 is a resistor R3. The switching switch 32 is a switch device K1. The isolation switch 34 is a switch device K. One end of the resistor R1 is connected to a positive end BUS+ of a direct current bus, and the other end is connected to a PE wire through the resistor R2 for grounding. One end of the resistor R3 is connected to a negative end BUS- of the direct current bus, and the other end is connected to a PE wire for grounding. The switching switch 32 is connected in parallel to the resistor R2. One end of the isolation switch 34 is connected to the output end of the inverter circuit 2, and the other end is connected to BUS- through the resistor Ro2.

In Embodiment 5, the detection circuit 3 further includes an isolation capacitor C, where the isolation capacitor C is disposed in the alternating current voltage detection circuit 33. Specifically, as shown in FIG. 5E, one end of the isolation capacitor C is connected to the negative end BUS- of the direct current bus, and the other end is connected to a PE wire through the resistor Ro1 for grounding.

According to such a design, when the controller 4 controls the isolation switch 34 to be turned off, a connection between the output end of the inverter circuit 2 and BUS- is disconnected, so that a closed connection path including the direct current bus, the insulation impedance detection circuit 31, the alternating current voltage detection circuit 33, the output end of the inverter circuit 2, the Y capacitor, and the ground is disconnected. In this way, the Y capacitor on the output end of the inverter circuit 2 cannot be charged to generate a virtual voltage. The isolation capacitor C may block the direct current, and therefore can further ensure that the direct current cannot be transmitted to the capacitor Y. In this way, a problem that a person is caused to suffer an electric shock and hand numbness via the output end of the inverter circuit 2 can be resolved. When the controller 4 controls the isolation switch 34 to be turned on, the output end of the inverter circuit 2 is connected to BUS-.

It may be understood that a process in which the controller 4 controls the switching switch 32 and calculates the insulation impedance is the same as or similar to that in Embodiment 1. Details are not described herein again.

### Embodiment 6

As shown in FIG. 5F, in a power conversion apparatus 100f, the insulation impedance detection circuit 31 includes the first impedance element 311 and the second impedance element 312. The switching switch 32 is a switch device K1. The isolation switch 34 is a switch device K. The alternating current voltage detection circuit 33 includes resistors Ro1 and Ro2.

A difference between the power conversion apparatus 100f in Embodiment 6 and the power conversion apparatus 100e in Embodiment 5 lies in a structure of the first impedance element 311 and a connection relationship between the first impedance element 311 and the switching switch 32.

As shown in FIG. 5F, the first impedance element 311 is a resistor R1, and the second impedance element 312 is a resistor R2. One end of the resistor R1 is connected to BUS+, and the other end is connected to a PE wire through the switching switch 32 for grounding. One end of the resistor R2 is connected to BUS-, and the other end is connected to a PE wire for grounding. One end of the isolation switch 34 is connected to the output end of the inverter circuit 2, and the other end is connected to BUS- through the resistor Ro2. One end of an isolation capacitor C is connected to the negative end BUS- of the direct current bus, and the other end is connected to a PE wire through the resistor Ro1 for grounding.

It may be understood that, for a process in which the controller 4 controls the isolation switch 34 and the switching switch 32, and calculates the insulation impedance, refer to Embodiment 5. Details are not described herein again.

### Embodiment 7

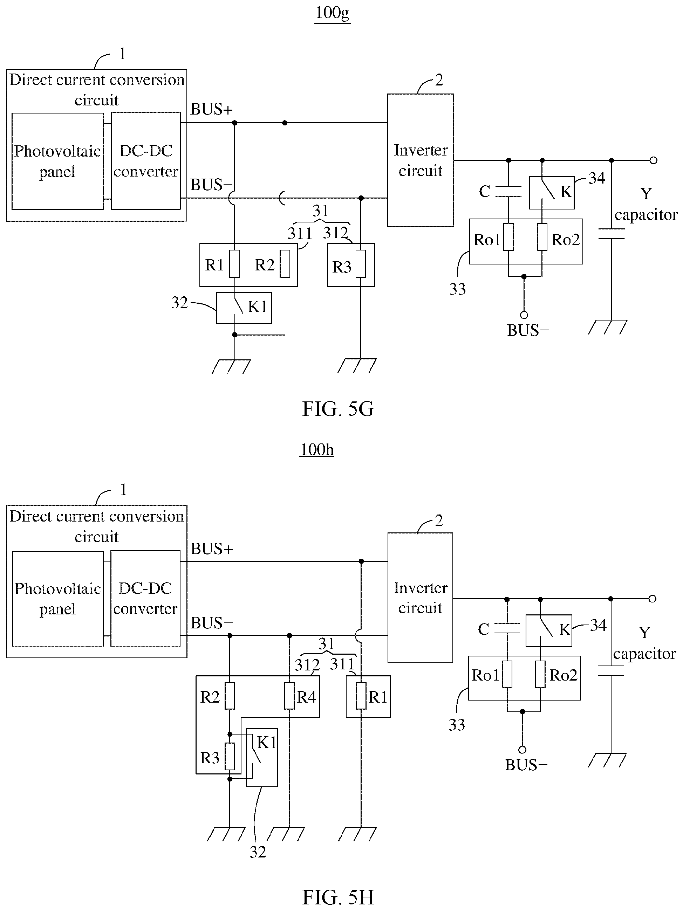

As shown in FIG. 5G, in a power conversion apparatus 100g, the insulation impedance detection circuit 31 includes the first impedance element 311 and the second impedance element 312. The switching switch 32 is a switch device K1. The isolation switch 34 is a switch device K. The alternating current voltage detection circuit 33 includes resistors Ro1 and Ro2.

A difference between the power conversion apparatus 100g in Embodiment 7 and the power conversion apparatus 100e in Embodiment 5 lies in a structure of the first impedance element 311 and a connection relationship between the first impedance element 311 and the switching switch 32.

As shown in FIG. 5G, the first impedance element 311 includes resistors R1 and R2, and the second impedance element 312 is a resistor R3. One end of the resistor R1 is connected to BUS+, and the other end is connected to a PE wire through the switching switch 32 for grounding. One end of the resistor R2 is connected to BUS+, and the other end is connected to a PE wire for grounding. One end of the resistor R3 is connected to BUS-, and the other end is connected to a PE wire for grounding. One end of the isolation switch 34 is connected to the output end of the inverter circuit 2, and the other end is connected to BUS- through the resistor Ro2. One end of an isolation capacitor C is connected to the negative end BUS- of the direct current bus, and the other end is connected to a PE wire through the resistor Ro1 for grounding.

It may be understood that, for a process in which the controller 4 controls the isolation switch 34 and the switching switch 32, and calculates the insulation impedance, refer to Embodiment 5. Details are not described herein again.

It may be understood that, in some implementations, the switching switch 32 may also be disposed between the resistor R2 and the PE wire, so that normal working of the power conversion apparatus 100g in Embodiment 7 is not affected.

### Embodiment 8

As shown in FIG. 5H, in a power conversion apparatus 100h, the insulation impedance detection circuit 31 includes the first impedance element 311 and the second impedance element 312. The switching switch 32 is a switch device K1. The isolation switch 34 is a switch device K. The alternating current voltage detection circuit 33 includes resistors Ro1 and Ro2.

A difference between the power conversion apparatus 100h in Embodiment 8 and the power conversion apparatus 100e in Embodiment 5 lies in structures of the first impedance element 311 and the second impedance element 312 and connection relationships between the first impedance element 311, the second impedance element 312, and the switching switch 32.

As shown in FIG. 5H, the first impedance element 311 is a resistor R1, and the second impedance element 312 includes resistors R2, R3, and R4. One end of the resistor R1 is connected to a positive end BUS+ of a direct current bus, and the other end is connected to a PE wire for grounding. One end of the resistor R2 is connected to a negative end BUS- of the direct current bus, and the other end is connected to a PE wire through the resistor R3 for grounding. The switching switch 32 is connected in parallel to the resistor R3. One end of the resistor R4 is connected to the negative end BUS- of the direct current bus, and the other end is connected to a PE wire for grounding. One end of the isolation switch 34 is connected to the output end of the inverter circuit 2, and the other end is connected to BUS- through the resistor Ro2. One end of an isolation capacitor C is connected to the negative end BUS- of the direct current bus, and the other end is connected to a PE wire through the resistor Ro1 for grounding.

It may be understood that, for a process in which the controller 4 controls the isolation switch 34 and the switching switch 32, and calculates the insulation impedance, refer to Embodiment 5. Details are not described herein again.

### Embodiment 9

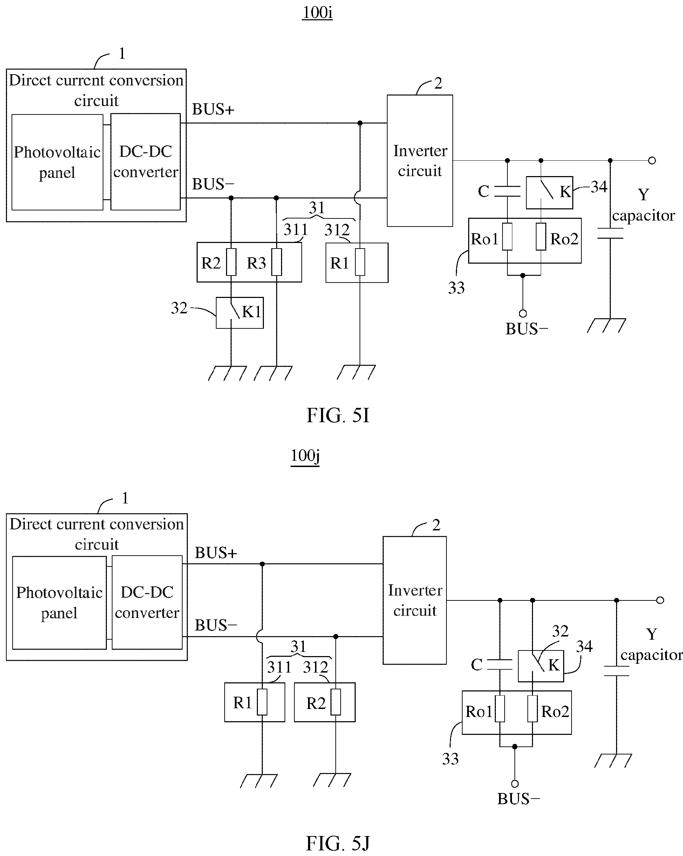

As shown in FIG. 5I, in a power conversion apparatus 100i, the insulation impedance detection circuit 31 includes the first impedance element 311 and the second impedance element 312. The switching switch 32 is a switch device K1. The isolation switch 34 is a switch device K. The alternating current voltage detection circuit 33 includes resistors Ro1 and Ro2.

A difference between the power conversion apparatus 100i in Embodiment 9 and the power conversion apparatus 100e in Embodiment 5 lies in structures of the first impedance element 311 and the second impedance element 312 and connection relationships between the first impedance element 311, the second impedance element 312, and the switching switch 32.

As shown in FIG. 5I, the first impedance element 311 is a resistor R1, and the second impedance element 312 includes resistors R2 and R3. One end of the resistor R1 is connected to BUS+, and the other end is connected to a PE wire for grounding. One end of the resistor R2 is connected to BUS-, and the other end is connected to a PE wire through the switching switch 32 for grounding. One end of the resistor R3 is connected to BUS-, and the other end is connected to a PE wire for grounding. One end of the isolation switch 34 is connected to the output end of the inverter circuit 2, and the other end is connected to BUS- through the resistor Ro2. One end of an isolation capacitor C is connected to the negative end BUS- of the direct current bus, and the other end is connected to a PE wire through the resistor Ro1 for grounding.

It may be understood that, for a process in which the controller 4 controls the isolation switch 34 and the switching switch 32, and calculates the insulation impedance, refer to Embodiment 5. Details are not described herein again.

### Embodiment 10

As shown in FIG. 5J, in a power conversion apparatus 100j, the insulation impedance detection circuit 31 includes the first impedance element 311 and the second impedance element 312. The alternating current voltage detection circuit 33 includes resistors Ro1 and Ro2.

A difference between the power conversion apparatus 100j in Embodiment 10 and the power conversion apparatus 100e in Embodiment 5 lies in the first impedance element 311, the isolation switch 34, and the switching switch 32.

As shown in FIG. 5J, the first impedance element 311 is a resistor R1, and the second impedance element 312 is a resistor R2. One end of the resistor R1 is connected to BUS+, and the other end is connected to a PE wire for grounding. One end of the resistor R2 is connected to BUS-, and the other end is connected to a PE wire for grounding. The isolation switch 34 is a switch device K, and the isolation switch 34 is reused as the switching switch 32. One end of the isolation switch 34 is connected to the output end of the inverter circuit 2, and the other end is connected to BUS- through the resistor Ro2. One end of an isolation capacitor C is connected to the negative end BUS- of the direct current bus, and the other end is connected to a PE wire through the resistor Ro1 for grounding.

It may be understood that, for a process in which the controller 4 controls the isolation switch 34 (that is, the switching switch 32) and calculates the insulation impedance, refer to Embodiment 5. Details are not described herein again.

In conclusion, in the power conversion apparatus in embodiments of this application, the isolation switch 34 is disposed to connect to the insulation impedance detection circuit 31 and the alternating current voltage detection circuit 33, and before the insulation impedance detection circuit 31 detects the voltage between the direct current bus and the ground, the isolation switch 34 is controlled to be turned off, so that the direct current conversion circuit 1 is disconnected from the output end of the inverter circuit 2. In this way, a virtual voltage that may cause a person to suffer an electric shock and hand numbness cannot be generated when the Y capacitor on the output end of the inverter circuit 2 is charged, so that a problem that a person is still caused to suffer an electric shock and hand numbness when the power conversion apparatus is not working is resolved. In this way, safety of the power conversion apparatus in embodiments of this application is improved, and user safety experience is improved.

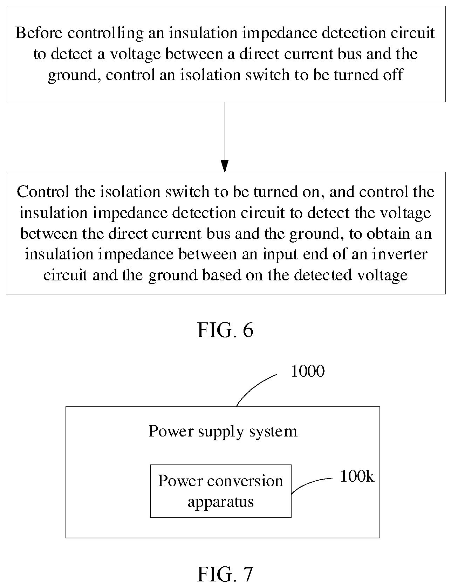

Refer to FIG. 6. An embodiment of this application further provides an insulation impedance detection method, which may be applied to the power conversion apparatuses 100, 100a, 100b, 100c, 100d, 100e, 100f, 100g, 100h, 100i and 100j in FIG. 3 to FIG. 5J.

As shown in FIG. 6, the insulation impedance detection method includes the following steps:

Before controlling the insulation impedance detection circuit 31 to detect a voltage between the direct current bus and the ground, the controller 4 controls the isolation switch 34 to be turned off.

According to such a design, a short circuit may occur between the direct current conversion circuit 1 and the output end of the inverter circuit 2, to prevent the Y capacitor on the output end of the inverter circuit 2 from obtaining a direct current generated by the direct current conversion circuit 1, so that a virtual voltage that may cause a person to suffer an electric shock and hand numbness cannot be generated.

It can also be seen from this that, before the insulation impedance detection circuit 31 is controlled to detect the voltage between the direct current bus and the ground, the controller 4 controls the direct current conversion circuit 1 to be in a working state.

In a process of controlling the insulation impedance detection circuit 31 to detect the voltage between the direct current bus and the ground, the controller 4 controls the isolation switch 34 to be turned on, and controls the insulation impedance detection circuit 31 to detect the voltage between the direct current bus and the ground. Further, the controller 4 obtains an insulation impedance between the input end of the inverter circuit 2 and the ground based on the detected voltage.

It may be understood that, for a process of the foregoing steps, refer to the descriptions of the power conversion apparatuses 100, 100a, 100b, 100c, 100d, 100e, 100f, 100g, 100h, 100i and 100j in FIG. 3 to FIG. 5J. Details are not described herein again.

In this embodiment of this application, the insulation impedance detection method may further include the following step:

When controlling the isolation switch 34 to be turned off, the controller 4 controls the inverter circuit 2 not to work.

In this embodiment of this application, the insulation impedance detection method may further include the following steps:

The controller 4 determines whether the insulation impedance between the input end of the inverter circuit 2 and the ground is less than a preset impedance value.

When it is determined that the insulation impedance between the input end of the inverter circuit 2 and the ground is less than the preset impedance value, the controller 4 controls the inverter circuit 2 not to work.

When it is determined that the insulation impedance between the input end of the inverter circuit 2 and the ground is not less than the preset impedance value, the controller 4 controls the inverter circuit 2 to work.

As shown in FIG. 7, an embodiment of this application further provides a power supply system 1000.

It may be understood that the power supply system 1000 may be a photovoltaic system, an uninterruptible power supply (Uninterruptible Power Supply, UPS) system, a vehicle-mounted charging system, a charging pile system, or another power supply system that can perform insulation impedance detection. This is not specifically limited herein.

The power supply system 1000 includes a power conversion apparatus 100k. It may be understood that the power conversion apparatus 100k may be the power conversion apparatuses 100, 100a, 100b, 100c, 100d, 100e, 100f, 100g, 100h, 100i and 100j in FIG. 3 to FIG. 5J, and may implement the insulation impedance detection method shown in FIG. 6.

All functional units in embodiments of this application may be integrated into one processing unit, each unit may be separately used as one unit, or two or more units may be integrated into one unit. The integrated units may be implemented in a form of hardware, or may be implemented in a form of a hardware plus software functional unit.

If the integrated unit in this application is implemented in a form of a software functional module and sold or used as an independent product, the integrated unit may also be stored in a computer-readable storage medium. Based on such an understanding, the technical solutions of embodiments of this application essentially, or the part contributing to the conventional technology may be implemented in a form of a software product. The computer software product is stored in a storage medium, and includes several instructions for instructing a computer device (which may be a personal computer, a server, or a network device) to perform all or a part of the methods described in embodiments of this application. The foregoing storage medium includes various media that can store program code, such as a removable storage device, a ROM, a RAM, a magnetic disk, or a compact disc.

## Claims

1. A power conversion apparatus, comprising a direct current conversion circuit, an inverter circuit, a detection circuit, and a controller, wherein
the direct current conversion circuit is configured to output a direct current voltage;
an input end of the inverter circuit is connected to the direct current conversion circuit through a direct current bus, and is configured to convert the direct current voltage into an alternating current voltage, and an output end of the inverter circuit is grounded through a Y capacitor;
the detection circuit comprises an insulation impedance detection circuit and an alternating current voltage detection circuit, the insulation impedance detection circuit is connected to the direct current bus and the ground, and is configured to detect a voltage between the direct current bus and the ground, and the alternating current voltage detection circuit is connected to the output end of the inverter circuit and the direct current bus, and is configured to detect the alternating current voltage;
the detection circuit comprises an isolation switch, and the isolation switch is connected to the insulation impedance detection circuit and the alternating current voltage detection circuit; and
the controller is connected to the isolation switch and the insulation impedance detection circuit, and is configured to: control the isolation switch to be turned on, and control the insulation impedance detection circuit to detect the voltage between the direct current bus and the ground, to obtain insulation impedance based on the detected voltage; and control the isolation switch to be turned off before controlling the insulation impedance detection circuit to detect the voltage between the direct current bus and the ground.

2. The power conversion apparatus according to claim **1,** wherein the isolation switch is disposed in the insulation impedance detection circuit, and/or disposed in the alternating current voltage detection circuit.

3. The power conversion apparatus according to claim 1 or 2, wherein the detection circuit further comprises a switching switch, and the switching switch is connected to the insulation impedance detection circuit and the controller; and
when controlling the isolation switch to be turned on, the controller is further configured to: control the switching switch to be turned on, and control the insulation impedance detection circuit to detect a first voltage between the direct current bus and the ground; and control the switching switch to be turned off, and control the insulation impedance detection circuit to detect a second voltage between the direct current bus and the ground, to obtain the insulation impedance based on the first voltage and the second voltage.

4. The power conversion apparatus according to claim 3, wherein the insulation impedance detection circuit comprises a first impedance element and a second impedance element, the first impedance element is connected to a positive end of the direct current bus and the ground, the second impedance element is connected to a negative end of the direct current bus and the ground, and the switching switch is connected to the first impedance element and the ground, or the switching switch is connected to the second impedance element and the ground; and
when the switching switch is connected to the first impedance element and the ground, an equivalent impedance of the first impedance element when the switching switch is turned on is different from an equivalent impedance of the first impedance element when the switching switch is turned off, and an equivalent impedance of the second impedance element when the switching switch is turned on is the same as an equivalent impedance of the second impedance element when the switching switch is turned off; or
when the switching switch is connected to the second impedance element and the ground, an equivalent impedance of the second impedance element when the switching switch is turned on is different from an equivalent impedance of the second impedance element when the switching switch is turned off, and an equivalent impedance of the first impedance element when the switching switch is turned on is the same as an equivalent impedance of the first impedance element when the switching switch is turned off.

5. The power conversion apparatus according to claim 3 or 4, wherein both the first voltage and the second voltage are voltages between the negative end of the direct current bus and the ground.

6. The power conversion apparatus according to any one of claims 1 to 5, wherein the controller is further configured to:
when the isolation switch is controlled to be turned off, control the inverter circuit not to work.

7. An insulation impedance detection method, applied to a power conversion apparatus, wherein the power conversion apparatus comprises a direct current conversion circuit, an inverter circuit, a detection circuit, and a controller, an input end of the inverter circuit is connected to the direct current conversion circuit through a direct current bus, an output end of the inverter circuit is grounded through a Y capacitor, the detection circuit comprises an insulation impedance detection circuit and an alternating current voltage detection circuit, the insulation impedance detection circuit is connected to the direct current bus and the ground, the alternating current voltage detection circuit is connected to the output end of the inverter circuit and the direct current bus, and the insulation impedance detection method comprises:
controlling an isolation switch to be turned on, and controlling the insulation impedance detection circuit to detect a voltage between the direct current bus and the ground, to obtain the insulation impedance based on the detected voltage, wherein the isolation switch is connected to the insulation impedance detection circuit and the alternating current voltage detection circuit; and
before controlling the insulation impedance detection circuit to detect the voltage between the direct current bus and the ground, controlling the isolation switch to be turned off.

8. The insulation impedance detection method according to claim 7, wherein the detection circuit further comprises a switching switch, and the switching switch is connected to the insulation impedance detection circuit and the controller; and
when the isolation switch is controlled to be turned on, the insulation impedance detection method further comprises:
controlling the switching switch to be turned on, and controlling the insulation impedance detection circuit to detect a first voltage between the direct current bus and the ground;
controlling the switching switch to be turned off, and controlling the insulation impedance detection circuit to detect a second voltage between the direct current bus and the ground; and
obtaining the insulation impedance based on the first voltage and the second voltage.

9. The insulation impedance detection method according to claim 8, wherein the insulation impedance detection circuit comprises a first impedance element and a second impedance element, the first impedance element is connected to a positive end of the direct current bus and the ground, the second impedance element is connected to a negative end of the direct current bus and the ground, and the switching switch is connected to the first impedance element and the ground, or the switching switch is connected to the second impedance element and the ground; and
when the switching switch is connected to the first impedance element and the ground, an equivalent impedance of the first impedance element when the switching switch is turned on is different from an equivalent impedance of the first impedance element when the switching switch is turned off, and an equivalent impedance of the second impedance element when the switching switch is turned on is the same as an equivalent impedance of the second impedance element when the switching switch is turned off; or
when the switching switch is connected to the second impedance element and the ground, an equivalent impedance of the second impedance element when the switching switch is turned on is different from an equivalent impedance of the second impedance element when the switching switch is turned off, and an equivalent impedance of the first impedance element when the switching switch is turned on is the same as an equivalent impedance of the first impedance element when the switching switch is turned off; and
the insulation impedance detection method further comprises:
establishing a system of equations based on shunting of the equivalent impedances of the first impedance element and the second impedance element when the switching switch is turned on, and the equivalent impedances of the first impedance element and the second impedance element when the switching switch is turned off; and
substituting the first voltage and the second voltage into the system of equations, to obtain the insulation impedance through calculation.

10. The insulation impedance detection method according to any one of claims 7 to 9, wherein the insulation impedance detection method further comprises:
when the isolation switch is controlled to be turned off, controlling the inverter circuit not to work.

11. The insulation impedance detection method according to claim 7, wherein the isolation switch is disposed in the insulation impedance detection circuit, and/or disposed in the alternating current voltage detection circuit.

12. The insulation impedance detection method according to any one of claims 8 to 9, wherein both the first voltage and the second voltage are voltages between the negative end of the direct current bus and the ground.

## Patentansprüche

1. Leistungsumwandlungseinrichtung, die eine Gleichstromumwandlungsschaltung, eine Wechselrichterschaltung, eine Detektionsschaltung und eine Steuerung umfasst, wobei
die Gleichstromumwandlungsschaltung dazu ausgelegt ist, eine Gleichspannung auszugeben;
ein Eingangsende der Wechselrichterschaltung über einen Gleichstrombus mit der Gleichstromumwandlungsschaltung verbunden ist und dazu ausgelegt ist, die Gleichspannung in eine Wechselspannung umzuwandeln, und ein Ausgangsende der Wechselrichterschaltung über einen Y-Kondensator auf Masse gelegt ist;
die Detektionsschaltung eine Isolationsimpedanzdetektionsschaltung und eine Wechselspannungsdetektionsschaltung umfasst, die Isolationsimpedanzdetektionsschaltung mit dem Gleichstrombus und der Masse verbunden ist und dazu ausgelegt ist, eine Spannung zwischen dem Gleichstrombus und der Masse zu detektieren, und die Wechselspannungsdetektionsschaltung mit dem Ausgangsende der Wechselrichterschaltung und dem Gleichstrombus verbunden ist und dazu ausgelegt ist, die Wechselspannung zu detektieren;
die Detektionsschaltung einen Trennschalter umfasst und der Trennschalter mit der Isolationsimpedanzdetektionsschaltung und der Wechselspannungsdetektionsschaltung verbunden ist; und
die Steuerung mit dem Trennschalter und der Isolationsimpedanzdetektionsschaltung verbunden ist und zu Folgendem ausgelegt ist: Steuern des Trennschalters, sodass er eingeschaltet wird, und Steuern der Isolationsimpedanzdetektionsschaltung zum Detektieren der Spannung zwischen dem Gleichstrombus und der Masse, um eine Isolationsimpedanz basierend auf der detektierten Spannung zu erhalten; und Steuern des Trennschalters, sodass er ausgeschaltet wird, bevor die Isolationsimpedanzdetektionsschaltung zum Detektieren der Spannung zwischen dem Gleichstrombus und der Masse gesteuert wird.

2. Leistungsumwandlungseinrichtung nach Anspruch 1, wobei der Trennschalter in der Isolationsimpedanzdetektionsschaltung angeordnet ist und/oder in der Wechselspannungsdetektionsschaltung angeordnet ist.

3. Leistungsumwandlungseinrichtung nach Anspruch 1 oder 2, wobei die Detektionsschaltung ferner einen Schaltschalter umfasst und der Schaltschalter mit der Isolationsimpedanzdetektionsschaltung und der Steuerung verbunden ist; und
die Steuerung beim Steuern des Trennschalters, sodass er eingeschaltet wird, ferner zu Folgendem ausgelegt ist: Steuern des Schaltschalters, sodass er eingeschaltet wird, und Steuern der Isolationsimpedanzdetektionsschaltung zum Detektieren einer ersten Spannung zwischen dem Gleichstrombus und der Masse; und Steuern des Schaltschalters, sodass er ausgeschaltet wird, und Steuern der Isolationsimpedanzdetektionsschaltung zum Detektieren einer zweiten Spannung zwischen dem Gleichstrombus und der Masse, um die Isolationsimpedanz basierend auf der ersten Spannung und der zweiten Spannung zu erhalten.

4. Leistungsumwandlungseinrichtung nach Anspruch 3, wobei die Isolationsimpedanzdetektionsschaltung ein erstes Impedanzelement und ein zweites Impedanzelement umfasst, das erste Impedanzelement mit einem positiven Ende des Gleichstrombusses und der Masse verbunden ist, das zweite Impedanzelement mit einem negativen Ende des Gleichstrombusses und der Masse verbunden ist und der Schaltschalter mit dem ersten Impedanzelement und der Masse verbunden ist oder der Schaltschalter mit dem zweiten Impedanzelement und der Masse verbunden ist; und
wenn der Schaltschalter mit dem ersten Impedanzelement und der Masse verbunden ist, sich eine Ersatzimpedanz des ersten Impedanzelements, wenn der Schaltschalter eingeschaltet ist, von einer Ersatzimpedanz des ersten Impedanzelements, wenn der Schaltschalter ausgeschaltet ist, unterscheidet und eine Ersatzimpedanz des zweiten Impedanzelements, wenn der Schaltschalter eingeschaltet ist, gleich einer Ersatzimpedanz des zweiten Impedanzelements ist, wenn der Schaltschalter ausgeschaltet ist; oder
wenn der Schaltschalter mit dem zweiten Impedanzelement und der Masse verbunden ist, sich eine Ersatzimpedanz des zweiten Impedanzelements, wenn der Schaltschalter eingeschaltet ist, von einer Ersatzimpedanz des zweiten Impedanzelements, wenn der Schaltschalter ausgeschaltet ist, unterscheidet und eine Ersatzimpedanz des ersten Impedanzelements, wenn der Schaltschalter eingeschaltet ist, gleich einer Ersatzimpedanz des ersten Impedanzelements ist, wenn der Schaltschalter ausgeschaltet ist.

5. Leistungsumwandlungseinrichtung nach Anspruch 3 oder 4, wobei sowohl die erste Spannung als auch die zweite Spannung Spannungen zwischen dem negativen Ende des Gleichstrombusses und der Masse sind.

6. Leistungswandlungseinrichtung nach einem der Ansprüche 1 bis 5, wobei die Steuerung ferner zu Folgendem ausgelegt ist:
wenn der Trennschalter so gesteuert wird, dass er ausgeschaltet wird, Steuern der Wechselrichterschaltung, sodass sie nicht arbeitet.

7. Isolationsimpedanzdetektionsverfahren, das auf eine Leistungsumwandlungseinrichtung angewendet wird, wobei die Leistungsumwandlungseinrichtung eine Gleichstromumwandlungsschaltung, eine Wechselrichterschaltung, eine Detektionsschaltung und eine Steuerung umfasst, ein Eingangsende der Wechselrichterschaltung über einen Gleichstrombus mit der Gleichstromumwandlungsschaltung verbunden ist, ein Ausgangsende der Wechselrichterschaltung über einen Y-Kondensator auf Masse gelegt ist, die Detektionsschaltung eine Isolationsimpedanzdetektionsschaltung und eine Wechselspannungsdetektionsschaltung umfasst, die Isolationsimpedanzdetektionsschaltung mit dem Gleichstrombus und der Masse verbunden ist, die Wechselspannungsdetektionsschaltung mit dem Ausgangsende der Wechselrichterschaltung und dem Gleichstrombus verbunden ist und das Isolationsimpedanzdetektionsverfahren Folgendes umfasst:
Steuern eines Trennschalters, sodass er eingeschaltet wird, und Steuern der Isolationsimpedanzdetektionsschaltung zum Detektieren einer Spannung zwischen dem Gleichstrombus und der Masse, um eine Isolationsimpedanz basierend auf der detektierten Spannung zu erhalten, wobei der Trennschalter mit der Isolationsimpedanzdetektionsschaltung und der Wechselspannungsdetektionsschaltung verbunden ist; und
vor dem Steuern der Isolationsimpedanzdetektionsschaltung zum Detektieren der Spannung zwischen dem Gleichstrombus und der Masse, Steuern des Trennschalters, sodass er ausgeschaltet wird.

8. Isolationsimpedanzdetektionsverfahren nach Anspruch 7, wobei die Detektionsschaltung ferner einen Schaltschalter umfasst und der Schaltschalter mit der Isolationsimpedanzdetektionsschaltung und der Steuerung verbunden ist; und
wenn der Trennschalter so gesteuert wird, dass er eingeschaltet wird, das Isolationsimpedanzdetektionsverfahren ferner Folgendes umfasst:
Steuern des Schaltschalters, sodass er eingeschaltet wird, und Steuern der Isolationsimpedanzdetektionsschaltung zum Detektieren einer ersten Spannung zwischen dem Gleichstrombus und der Masse;
Steuern des Schaltschalters, sodass er ausgeschaltet wird, und Steuern der Isolationsimpedanzdetektionsschaltung zum Detektieren einer zweiten Spannung zwischen dem Gleichstrombus und der Masse; und
Erhalten der Isolationsimpedanz basierend auf der ersten Spannung und der zweiten Spannung.

9. Isolationsimpedanzdetektionsverfahren nach Anspruch 8, wobei die Isolationsimpedanzdetektionsschaltung ein erstes Impedanzelement und ein zweites Impedanzelement umfasst, das erste Impedanzelement mit einem positiven Ende des Gleichstrombusses und der Masse verbunden ist, das zweite Impedanzelement mit einem negativen Ende des Gleichstrombusses und der Masse verbunden ist und der Schaltschalter mit dem ersten Impedanzelement und der Masse verbunden ist oder der Schaltschalter mit dem zweiten Impedanzelement und der Masse verbunden ist; und
wenn der Schaltschalter mit dem ersten Impedanzelement und der Masse verbunden ist, sich eine Ersatzimpedanz des ersten Impedanzelements, wenn der Schaltschalter eingeschaltet ist,
von einer Ersatzimpedanz des ersten Impedanzelements, wenn der Schaltschalter ausgeschaltet ist, unterscheidet und eine Ersatzimpedanz des zweiten Impedanzelements, wenn der Schaltschalter eingeschaltet ist, gleich einer Ersatzimpedanz des zweiten Impedanzelements ist, wenn der Schaltschalter ausgeschaltet ist; oder
wenn der Schaltschalter mit dem zweiten Impedanzelement und der Masse verbunden ist, sich eine Ersatzimpedanz des zweiten Impedanzelements, wenn der Schaltschalter eingeschaltet ist, von einer Ersatzimpedanz des zweiten Impedanzelements, wenn der Schaltschalter ausgeschaltet ist, unterscheidet und eine Ersatzimpedanz des ersten Impedanzelements, wenn der Schaltschalter eingeschaltet ist, gleich einer Ersatzimpedanz des ersten Impedanzelements ist, wenn der Schaltschalter ausgeschaltet ist; und
das Isolationsimpedanzdetektionsverfahren ferner Folgendes umfasst:
Einrichten eines Gleichungssystems basierend auf einem Nebenschluss der Ersatzimpedanzen des ersten Impedanzelements und des zweiten Impedanzelements, wenn der Schaltschalter eingeschaltet ist, und der Ersatzimpedanzen des ersten Impedanzelements und des zweiten Impedanzelements, wenn der Schaltschalter ausgeschaltet ist; und
Einsetzen der ersten Spannung und der zweiten Spannung in das Gleichungssystem, um die Isolationsimpedanz durch Berechnung zu erhalten.

10. Isolationsimpedanzdetektionsverfahren nach einem der Ansprüche 7 bis 9, wobei das Isolationsimpedanzdetektionsverfahren ferner Folgendes umfasst:
wenn der Trennschalter so gesteuert wird, dass er ausgeschaltet wird, Steuern der Wechselrichterschaltung, sodass sie nicht arbeitet.

11. Isolationsimpedanzdetektionsverfahren nach Anspruch 7, wobei der Trennschalter in der Isolationsimpedanzdetektionsschaltung angeordnet ist und/oder in der Wechselspannungsdetektionsschaltung angeordnet ist.

12. Isolationsimpedanzdetektionsverfahren nach einem der Ansprüche 8 bis 9, wobei sowohl die erste Spannung als auch die zweite Spannung Spannungen zwischen dem negativen Ende des Gleichstrombusses und der Masse sind.

## Revendications

1. Appareil de conversion de puissance, comprenant un circuit de conversion de courant continu, un circuit inverseur, un circuit de détection et un contrôleur, où
le circuit de conversion de courant continu est configuré pour délivrer en sortie une tension de courant continu ;
une extrémité d'entrée du circuit inverseur est connectée au circuit de conversion de courant continu par l'intermédiaire d'un bus de courant continu, et est configurée pour convertir la tension de courant continu en une tension de courant alternatif, et une extrémité de sortie du circuit inverseur est mise à la masse par l'intermédiaire d'un condensateur Y ;
le circuit de détection comprend un circuit de détection d'impédance d'isolation et un circuit de détection de tension de courant alternatif, le circuit de détection d'impédance d'isolation est connecté au bus de courant continu et à la masse, et est configuré pour détecter une tension entre le bus de courant continu et la masse, et le circuit de détection de tension de courant alternatif est connecté à l'extrémité de sortie du circuit inverseur et au bus de courant continu, et est configuré pour détecter la tension de courant alternatif ;
le circuit de détection comprend un commutateur d'isolation, et le commutateur d'isolation est connecté au circuit de détection d'impédance d'isolation et au circuit de détection de tension de courant alternatif ; et
le contrôleur est connecté au commutateur d'isolation et au circuit de détection d'impédance d'isolation, et est configuré pour : commander le commutateur d'isolation pour passer dans l'état passant, et commander le circuit de détection d'impédance d'isolation afin de détecter la tension entre le bus de courant continu et la masse, pour obtenir une impédance d'isolation sur la base de la tension détectée ; et commander le commutateur d'isolation pour l'ouvrir avant de commander le circuit de détection d'impédance d'isolation pour détecter la tension entre le bus de courant continu et la terre.

2. Appareil de conversion de puissance selon la revendication 1, dans lequel le commutateur d'isolation est disposé dans le circuit de détection d'impédance d'isolation, et/ou disposé dans le circuit de détection de tension de courant alternatif.

3. Appareil de conversion de puissance selon la revendication 1 ou la revendication 2, dans lequel le circuit de détection comprend en outre un commutateur de commutation, et le commutateur de commutation est connecté au circuit de détection d'impédance d'isolation et au contrôleur ; et
lorsque le commutateur d'isolation est commandé pour passer dans l'état passant, le contrôleur est en outre configuré pour : commander le commutateur de commutation pour passer dans l'état passant, et commander le circuit de détection d'impédance d'isolation afin de détecter une première tension entre le bus de courant continu et la masse ; et commander le commutateur de commutation dans l'état ouvert, et commander le circuit de détection d'impédance d'isolation pour détecter une deuxième tension entre le bus de courant continu et la masse, pour obtenir l'impédance d'isolation sur la base de la première tension et de la deuxième tension.

4. Appareil de conversion de puissance selon la revendication 3, dans lequel le circuit de détection d'impédance d'isolation comprend un premier élément d'impédance et un deuxième élément d'impédance, le premier élément d'impédance est connecté à une extrémité positive du bus de courant continu et à la masse, le deuxième élément d'impédance est connecté à une extrémité négative du bus de courant continu et à la masse, et le commutateur de commutation est connecté au premier élément d'impédance et à la masse, ou le commutateur de commutation est connecté au deuxième élément d'impédance et à la masse ; et
lorsque le commutateur de commutation est connecté au premier élément d'impédance et à la masse, une impédance équivalente du premier élément d'impédance, lorsque le commutateur de commutation est dans l'état passant, est différente d'une impédance équivalente du premier élément d'impédance lorsque le commutateur de commutation est dans l'état ouvert, et une impédance équivalente du deuxième élément d'impédance, lorsque le commutateur de commutation est dans l'état passant, est la même qu'une impédance équivalente du deuxième élément d'impédance lorsque le commutateur de commutation est dans l'état ouvert ; ou
lorsque le commutateur de commutation est connecté au deuxième élément d'impédance et à la masse, une impédance équivalente du deuxième élément d'impédance, lorsque le commutateur de commutation est dans l'état passant, est différente d'une impédance équivalente du deuxième élément d'impédance lorsque le commutateur de commutation est dans l'état ouvert, et une impédance équivalente du premier élément d'impédance, lorsque le commutateur de commutation est dans l'état passant, est la même qu'une impédance équivalente du premier élément d'impédance lorsque le commutateur de commutation est dans l'état ouvert.

5. Appareil de conversion de puissance selon la revendication 3 ou la revendication 4, dans lequel à la fois la première tension et la deuxième tension sont des tensions entre l'extrémité négative du bus de courant continu et la masse.

6. Appareil selon l'une quelconque des revendications 1 à 5, dans lequel le contrôleur est en outre configuré pour :
lorsque le commutateur d'isolation est commandé pour être dans l'état ouvert, commander le circuit inverseur afin qu'il ne fonctionne pas.

7. Procédé de détection d'impédance d'isolation, appliqué à un appareil de conversion de puissance, l'appareil de conversion de puissance comprenant un circuit de conversion de courant continu, un circuit inverseur, un circuit de détection et un contrôleur, une extrémité d'entrée du circuit inverseur étant connectée au circuit de conversion de courant continu par l'intermédiaire d'un bus de courant continu, une extrémité de sortie du circuit inverseur étant mise à la masse par l'intermédiaire d'un condensateur Y, le circuit de détection comprenant un circuit de détection d'impédance d'isolation et un circuit de détection de tension de courant alternatif, le circuit de détection d'impédance d'isolation étant connecté au bus de courant continu et à la masse, le circuit de détection de tension de courant alternatif étant connecté à l'extrémité de sortie du circuit inverseur et au bus de courant continu, et le procédé de détection d'impédance d'isolation comprenant les étapes suivantes :
commander un commutateur d'isolation pour passer dans l'état passant et commander le circuit de détection d'impédance d'isolation pour détecter une tension entre le bus de courant continu et la masse, pour obtenir l'impédance d'isolation sur la base de la tension détectée, le commutateur d'isolation étant connecté au circuit de détection d'impédance d'isolation et au circuit de détection de tension de courant alternatif ; et
avant de commander le circuit de détection d'impédance d'isolation pour détecter la tension entre le bus de courant continu et la masse, commander le commutateur d'isolation pour le passer dans l'état ouvert.

8. Procédé de détection d'impédance d'isolation selon la revendication 7, dans lequel le circuit de détection comprend en outre un commutateur de commutation, et le commutateur de commutation est connecté au circuit de détection d'impédance d'isolation et au contrôleur ; et
lorsque le commutateur d'isolation est commandé pour passer dans l'état passant, le procédé de détection d'impédance d'isolation comprend en outre les étapes suivantes :
commander le commutateur de commutation pour passer dans l'état passant, et commander le circuit de détection d'impédance d'isolation pour détecter une première tension entre le bus de courant continu et la masse,
commander le commutateur de commutation pour passer dans l'état ouvert, et commander le circuit de détection d'impédance d'isolation pour détecter une deuxième tension entre le bus de courant continu et la masse ; et
obtenir l'impédance d'isolation sur la base de la première tension et de la deuxième tension.

9. Procédé de détection d'impédance d'isolation selon la revendication 8, dans lequel le circuit de détection d'impédance d'isolation comprend un premier élément d'impédance et un deuxième élément d'impédance, le premier élément d'impédance est connecté à une extrémité positive du bus de courant continu et à la masse, le deuxième élément d'impédance est connecté à une extrémité négative du bus de courant continu et à la masse, et le commutateur de commutation est connecté au premier élément d'impédance et à la masse. ou le commutateur de commutation est connecté au deuxième élément d'impédance et à la masse ; et
lorsque le commutateur de commutation est connecté au premier élément d'impédance et à la masse, une impédance équivalente du premier élément d'impédance, lorsque le commutateur de commutation est dans l'état passant, est différente d'une impédance équivalente du premier élément d'impédance lorsque le commutateur de commutation est dans l'état ouvert, et une impédance équivalente du deuxième élément d'impédance, lorsque le commutateur de commutation est dans l'état passant, est la même qu'une impédance équivalente du deuxième élément d'impédance lorsque le commutateur de commutation est dans l'état ouvert ; ou
lorsque le commutateur de commutation est connecté au deuxième élément d'impédance et à la masse, une impédance équivalente du deuxième élément d'impédance, lorsque le commutateur de commutation est dans l'état passant, est différente d'une impédance équivalente du deuxième élément d'impédance lorsque le commutateur de commutation est dans l'état ouvert, et une impédance équivalente du premier élément d'impédance, lorsque le commutateur de commutation est dans l'état passant, est la même qu'une impédance équivalente du premier élément d'impédance lorsque le commutateur de commutation est dans l'état ouvert ; et
le procédé de détection d'impédance d'isolation comprend en outre les étapes suivantes :
établir un système d'équations basé sur la dérivation des impédances équivalentes du premier élément d'impédance et du deuxième élément d'impédance lorsque le commutateur de commutation est dans l'état passant, et des impédances équivalentes du premier élément d'impédance et du deuxième élément d'impédance lorsque le commutateur de commutation est dans l'état ouvert ; et
substituer la première tension et la deuxième tension dans le système d'équations, pour obtenir l'impédance d'isolation par calcul.

10. Procédé de détection d'impédance d'isolation selon l'une quelconque des revendications 7 à 9, le procédé de détection d'impédance d'isolation comprenant en outre l'étape suivante :
lorsque le commutateur d'isolation est commandé pour être dans l'état ouvert, commander le circuit inverseur afin qu'il ne fonctionne pas.

11. Procédé de détection d'impédance d'isolation selon la revendication 7, dans lequel le commutateur d'isolation est disposé dans le circuit de détection d'impédance d'isolation, et/ou disposé dans le circuit de détection de tension de courant alternatif.

12. Procédé de détection d'impédance d'isolation selon l'une quelconque des revendications 8 et 9, dans lequel à la fois la première tension et la deuxième tension sont des tensions entre l'extrémité négative du bus de courant continu et la masse.
